(19) **Europäisches Patentamt**
**European Patent Office**
**Office européen des brevets**

(11) **EP 4 502 755 A1**

(12) **EUROPEAN PATENT APPLICATION**

(43) Date of publication:
**05.02.2025 Bulletin 2025/06**

(21) Application number: **24191603.0**

(22) Date of filing: **29.07.2024**

(51) International Patent Classification (IPC):
*G05F 1/46* (2006.01)    *H03F 1/02* (2006.01)
*H03F 1/14* (2006.01)    *H03F 1/22* (2006.01)
*H03F 3/393* (2006.01)    *H03F 3/45* (2006.01)
*G05F 3/26* (2006.01)

(52) Cooperative Patent Classification (CPC):
**H03F 3/393; H03F 1/0205; H03F 1/14; H03F 1/223;**
**H03F 3/45188; H03F 3/45475;** H03F 2200/144;
H03F 2200/153; H03F 2200/453; H03F 2200/456

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **02.08.2023 US 202318229652**

(71) Applicant: **Analog Devices International**
**Unlimited Company**
**Limerick (IE)**

(72) Inventors:
• **HURRELL, Christopher Peter**
**Co. Limerick (IE)**

• **DEMPSEY, Dennis A.**
**Co. Limerick (IE)**
• **THOMAS, Andrew**
**Wilmington, 01887 (US)**
• **O'HALLORAN, Micah**
**Wilmington, 01887 (US)**
• **SLOBODA, Alex**
**Wilmington, 01887 (US)**
• **MAURINO, Roberto Sergio Matteo**
**Co. Limerick (IE)**

(74) Representative: **Wallin, Nicholas James**
**Withers & Rogers LLP**
**2 London Bridge**
**London SE1 9RA (GB)**

(54) **BUFFER CIRCUIT**

(57)    The present disclosure provides a buffer amplifier arrangement (3) that seeks to find a solution to varying load configurations on an output of the buffer. To address this issue a current source that supplies an output of the buffer is divided into a fixed current source (I2) and a variable current source (I3) that provides current for the variable load (RLOAD). The variable current source (I3) is a programmable current source that can be varied based on the associated modulator mode bus. As such, the current source is adaptive to multiple differing loads. Further, this reduces the power inefficiency in the buffer, as there is less power wastage during 'sub-optimal' modulator modes. Moreover, since the adaptive current source can match the modulator modes the glitch effect will be greatly reduced resulting in a more stable output voltage due to power supply changes.

FIG. 3

## Description

### Technical Field

The present disclosure generally relates to stabilizing operation of a current mirror output circuit, specifically in the presence of load current or supply voltage variation, which may be used in conjunction with amplifier circuits and associated reference buffering. More specifically, the present disclosure relates to power supply rejection of a current mirror and using load information to control a variable current mirror.

The present disclosure seeks to improve the power supply rejection of a current source or current source circuit. For example, the present disclosure discusses measuring and correcting first order AC disturbing currents from the power supply to be used as part of a reference circuit driving the reference of an ADC, the reference for a DAC or driving precision analog circuit loads or the like.

### Background and Related Art

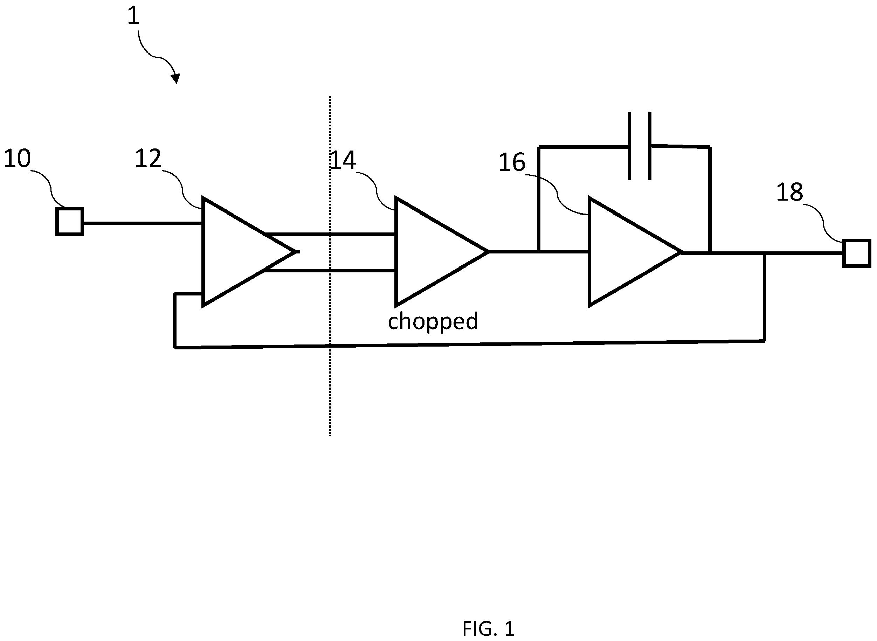

A known buffer amplifier architecture for amplifying a voltage reference for use in analog to digital conversion processes is shown in Figure 1. The buffer amplifier architecture comprises a first stage 12, a second stage 14, and a third stage 16, as shown. Whilst there is a plurality of different buffer amplifier arrangements, the first stage usually includes some kind of input transistor such as a junction field effect transistor (JFET) to provide both gain and high input impedance. It is a known technique that the second stage may provide additional gain and may include a chopping circuit of some sort for example a preamplifier circuit before a chopped amplifier stage [1] and the third stage, if required, will comprise the output amplifier or driver which may provide further gain and may provide a lowering of the output impedance. The circuit will also comprise an input node 10 and a corresponding output node 18. Reducing and limiting wastages and inaccuracies throughout the buffer amplifier architecture is of paramount importance in ensuring the accuracy of further devices downstream of the buffer amplifier such as analog to digital converters (ADCs). The third stage may be a Miller stage comprising the Miller capacitor in parallel with the output amplifier, or other compensation schemes and related variations including right-hand-pole (RHP) cancellation using series resistors, or the like.

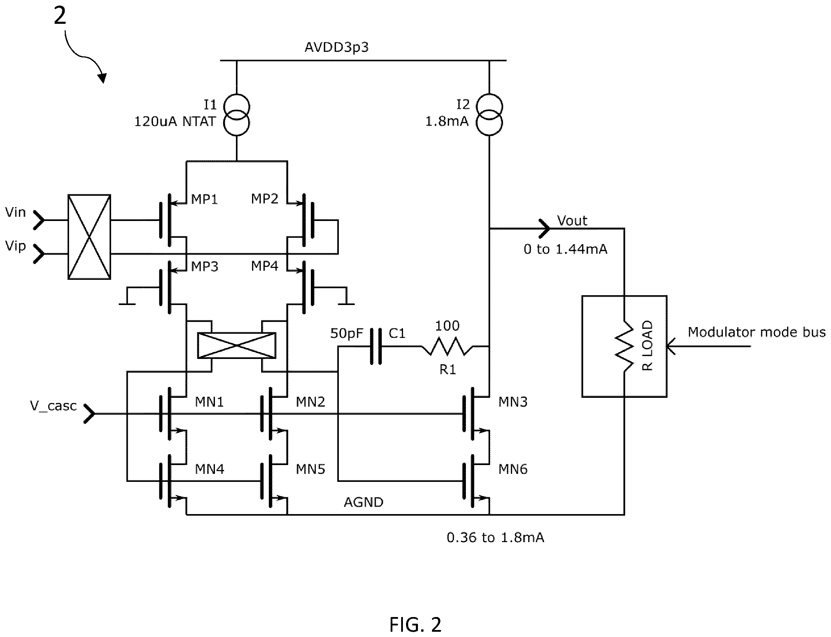

Figure 2 shows a circuit schematic of the second and third stages of the buffer amplifier architecture. The output of this circuit is used to drive a corresponding ADC arrangement; however, the output could drive a DAC arrangement, a precision load etc. In the circuit, the reference buffer incorporates a modulator mode bus that indicates varying different operating modes which is indicative of the number of downstream ADCs in operation, and whether the ADCs are single ended, differential etc. The variable DC load presented to Vout therefore relates to the operating mode as shown on the modulator mode bus. Since there are a plurality of differing operating modes, and thus different DC loads, the current source, I2, is sized for the maximum output load current. As such, this arrangement works optimally when the system digital control or control input which may be a modulator mode bus shows that the system is operating with the mode corresponding to the maximum output load current. However, in all other modes the current source, I2, is not optimally selected and as such the circuit is operating wastefully - this highlights a first weakness of legacy reference buffer circuitry. In an alternative arrangement the variable load current is supplied by a PMOS device with source coupled to AVDD3p3 and drain to Vout. This arrangement is more efficient as this PMOS devices only needs to supply the required load current, but it's known to those skilled in the art that when there is a Miller cap such as C1 between the drain and the source of such a device, then high frequency power supply noise can couple strongly to Vout.

Further, in chopped buffer amplifier circuitry gates of corresponding transistor devices can be considered to be at substantially the same voltage level, as these devices are operating at substantially the same current density. Therefore, when you chop, the gate voltages do not substantially change. However, in Figure 2 there is a varying load and thus variable current. Therefore, the gate voltages of the varying transistor devices will vary, for example, during sub-optimal modulator modes which do not require the full output current available from current source I2 the gate voltage of MN6 will vary from the gate voltage of MN4. This is problematic, as in this scenario, every time the chopping operation is performed a step will appear on the drains of MN1 and MN2 due to the unwanted voltage difference between the varying transistor devices gate voltages. This will cause glitching and instability on the output voltage of the circuit, wherein instability in this scenario relates to offset drift due to power supply changes, or changes over time or changes over temperature. The output of this circuit is used as a reference and as such the output needs to be as controlled and stable, or substantially constant, as possible. Therefore, a second weakness of legacy reference buffer circuitry is the voltage output glitching that occurs due to variable gate voltages on the transistor devices. The output glitches will ultimately contribute to buffer offset and offset drift. Reduced transient glitching is also desirable.

The legacy arrangement shown in Figure 2 therefore presents two problems - inefficiency due to the large current source I2 having to drive a wide range of possible loads depending on the state of the downstream ADC that is being driven, which in turn also leads to glitching voltages on the terminals of the transistors. The present disclosure provides an alternative buffer amplifier arrangement to limit and reduce the power inefficiencies and prevent the glitching on the voltage output. Thus, the present disclosure seeks to provide a buffer amplifier with improved power efficiency and improved voltage output instability performance.

DACs may have a code current dependency e.g. ladder DACs such as voltage-mode R/2R have a significant code dependency, such that the equivalent load presented by the DAC at the reference terminals varies significantly vs code. This code dependency can be measured or simulated. The nominal code dependency can be studied and understood using the information from the DAC architecture and micro-architecture details.

## Summary of the Invention

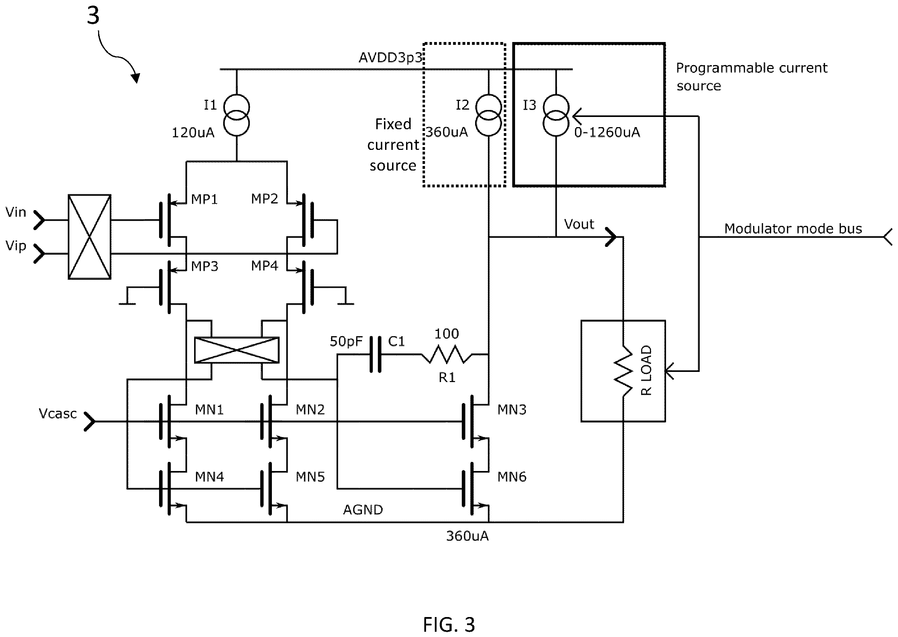

The present disclosure provides a buffer amplifier arrangement shown in Figure 3 configured to address the above problem, by introducing a variable current source (I3). The amplifier output stage may include a fixed current source, I2. Fundamentally, the buffer amplifier circuit seeks to find a solution to the varying load current due to load configurations, output modes, modulator modes etc. and the corresponding varying currents or voltages that appear at transistor devices throughout the circuit.. The variable current supply (I3) is, in this example, a programmable current source. Thus, the further current supply can be varied based on the associated modulator mode bus, for example, to match the load being presented to the buffer. As such, the current source is not optimized for only one load configuration, output mode, modulator mode or the like, but is adaptive to multiple differing loads, outputs, modulator modes etc. The current source does not necessarily have to be optimized for all load configurations, modulator modes etc. but rather for enough load configurations/modulation modes upon which it is deemed an optimal solution considering development effort, final cost and performance impact of adding additional modes. Further, this reduces the power inefficiency in the prior art, as there is less power wastage during 'sub-optimal' modulator modes. Moreover, since the adaptive current source can match the ADC modulator modes then there will be substantially no difference between the transistor gate voltage and therefore the glitch effect will be greatly reduced, resulting in a more stable output voltage.

The above mentioned programmable current source makes the buffer power efficient in all load configurations, output modes, modulator modes or the like. In doing so, MN4-6 of Figure 2 operate with largely the same current density under all load conditions (as do MN1,2,3). This therefore minimises the magnitude of chopping square waves on drains of MN1 and MN2. Thus, the amplifier only removes errors in the programmable current source.

In embodiments of the present invention, the buffer amplifier circuit is arranged such that a programmable current source, I3, may be used to map to the modulator mode. This is achieved via data from the system digital control or control input which in some cases may be a modulator mode bus, which provides data or information relating to the load configuration, output mode, modulator mode, or the like, into the programmable current source. The programmable current source can vary from providing no current up to providing a maximum current value and thus the programmable current source powers the variable load.

In other embodiments of the present invention, the buffer amplifier circuit is arranged such that control of a programmable current source, I3, uses the DAC current requirement code dependency information. It may also be used to drive alternative analog loads whilst using the load current information.

A first aspect of the present disclosure provides a buffer amplifier circuit, comprising at least one or more of: a driver that supplies current to a load in dependence on a voltage on the variable load; at least one variable current source, the variable current source being arranged in use to supply current to the variable load; and a control input receiving control information pertaining to a current demand of the load; the arrangement being such that the variable current source is controlled in dependence on the received control information to vary its output current such that current from the driver and the variable current source address the current requirements of the load, with at least a majority of the current requirements of the load being supplied by the variable current source.

A second aspect of the present disclosure provides a split current source circuit, comprising at least one or more of: a first operational amplifier, a first transistor device, a first impedance and a second impedance which are arranged to produce a first current through a first current source; a second operational amplifier and a second transistor device which arranged to produce a second current through a second current source; the second operational amplifier, the second transistor device, the first impedance and the second impedance being arranged to produce the second current through the second current source; and wherein the first current is a multiple of the second current, the multiple being dependent upon the relative values of the first and second impedances.

A third aspect of the present disclosure provides a current source circuit, comprising at least one or more of: a first components subsystem coupled between a supply and a critical node that produces a first AC current to flow into the critical node as a result of unwanted AC signals on the supply; a replica components subsystem coupled to the supply to produce a second AC current that is a ratioed replica of the first AC current; a replica bias circuit subsystem arranged in use to set bias conditions of the components within the replica components subsystem to be equal or equivalent to that of the components within the first components subsystem; and a current to voltage translator subsystem arranged in use to produce: i) a first signal via a first signal path which reduces the second AC current, wherein the first signal path couples the current to voltage translator subsystem to the replica components subsystem; and ii) a second signal via a second signal path which reduces the first AC current, wherein the second signal path couples the current to voltage translator subsystem to the first components subsystem.

Further features and advantages will be apparent from the appended claims.

## Brief Description of the Drawings

Further features and advantages of the present disclosure will become apparent from the following description of an embodiment thereof, presented by way of example only, and with reference to the accompanying drawings, wherein like reference numerals refer to like parts, and wherein:

Figure 1 shows a top-level system diagram of a buffer amplifier, in accordance with the prior art;

Figure 2 shows a schematic diagram of the second stage of the buffer amplifier (as in Figure 1), in accordance with the prior art;

Figure 3 shows a schematic diagram of a second stage of a buffer amplifier, in accordance with an embodiment of the present disclosure;

Figure 4a shows a schematic diagram of a programmable current source (as in Figure 3), in accordance with an embodiment of the present disclosure;

Figure 4b shows a block diagram of the programmable current source (as shown in Figure 4a), in accordance with an embodiment of the present disclosure;

Figure 4c shows a schematic diagram of the programmable current source (as shown in Figure 4a), in accordance with an embodiment of the present disclosure using switched cascode devices;

Figure 4d shows a more complete schematic diagram of a programmable current source (as in Figure 3), in accordance with an embodiment of the present disclosure;

Figure 5 shows an example frequency response graph which shows the effect of the circuit in the present disclosure in comparison to prior art circuitry;

Figure 6 shows a simplified circuit diagram of the schematic as shown in Figure 3, in accordance with an embodiment of the present disclosure;

Figure 7 shows a schematic diagram as in Figure 3 but where it is arranged to provide a clean current sources to a secondary circuit, in accordance with an embodiment of the present disclosure;

Figure 8 shows a schematic diagram depicting a split current source arrangement, in accordance with a further embodiment of the present disclosure.

## Detailed Description of the Preferred Embodiments

The present disclosure provides a buffer amplifier arrangement that seeks to find a solution to varying load impedance due to varying modulator modes on an output of the buffer and the corresponding varying currents or voltages that appear at transistor devices throughout the circuit. To address this issue, the current to the load is supplied by a variable current source that provides current for the variable load and a buffer amplifier that provides a compensation current to correct for any error in the variable current source. The variable current source may be a programmable current source that can be varied based on the associated modulator mode bus. As such, the current source is not optimized for only one modulator mode but is adaptive to multiple modulator modes. Further, this reduces the power inefficiency in the buffer, as there is less power wastage during 'sub-optimal' modulator modes. Moreover, since the adaptive current source can match the modulator modes the buffer amplifier only needs to supply correcting currents. There will then be little difference between the transistor gate voltages in corresponding chopped devices and the glitch effect will be greatly reduced resulting in a more stable output voltage.

In more detail, the present disclosure relates to a current source PSRR (power supply rejection ratio) improvement circuit whereby the output of a buffer amplifier is stabilised, or maintained at a more constant level in the presence of power supply variations, using a variable current source.

More particularly, in one embodiment the present disclosure relates, to a programmable current source circuit that can be used as a variable current source in conjunction with a buffer amplifier in order to map the load driving current to the variable downstream modulation mode.

As a brief non-limiting overview, the present disclosure is a buffer amplifier arrangement wherein the circuit comprises a variable current source, known as the programmable current source, which is adaptive to varying different modulator modes. As such, the programmable current source improves buffer power efficiency in multiple modulator operating modes. As seen in Figure 3, the programmable current source works to ensure the buffer transistors (MN4-6) operate with substantially the same current density under multiple modulator modes or load conditions. Therefore, this minimises the magnitude of chopping square waves on the drains of MN1/2. In other words, this prevents voltage glitching after each chopping operation to improve the stability of the output voltage.

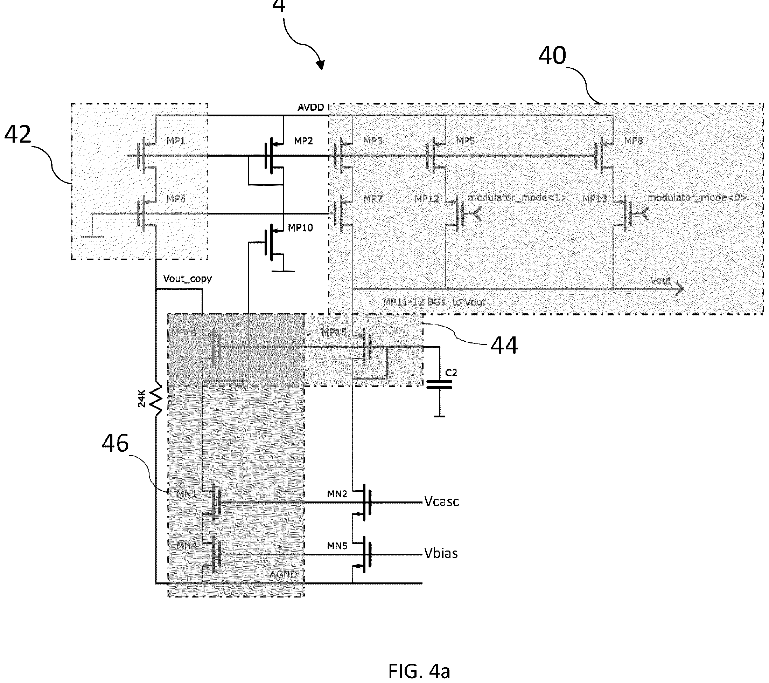

Referring to Figure 4a, the programmable current source is arranged to significantly reduce disturbance on the supply AVDD coupling to the output node Vout. This is achieved in part by creating an identical output voltage replica, Vout_copy, via diode connected device MP15 and source follower MP14. MP1 AC drain current, resulting from disturbances in the power supply AVDD, flows mostly through MP14 to the high impedance node at drain of MP14. Accordingly, the high impedance node is coupled via MP10 to the gate of MP1, such that the loop servos the MP1 AC current to substantially zero. Since MP1,3,5,8 gates are all connected and are arranged to have substantially the same terminal voltages, if MP1 AC drain current is substantially zero, then by matching, MP3,5,8 drain currents are also substantially zero, as they have the same terminal voltages as MP1. It should be noted that MP12 and MP13 act as switches with finite impedance under control of the modulator mode bus. MP6 and MP7 are shown having grounded gates and serve to ensure that MP1, MP3, MP5 and MP8 all have the same drain-source voltage. The MP6 and MP7 gates may also be coupled to a non-zero DC or quasi-DC level. The devices MP6 and MP7 replicate the 'on' conditions of devices MP12 and MP13, which are used as switches operating in their linear region of operation in the 'on' state. Using MP12 and MP13 in linear mode of operation allows the circuit to operate with low output compliance, useful for low supply operation and power efficiency.

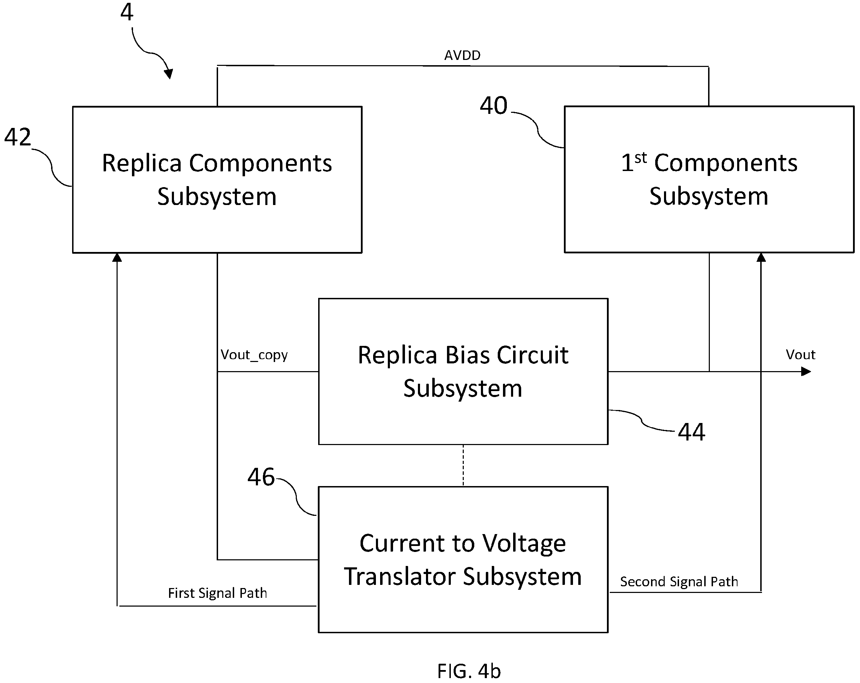

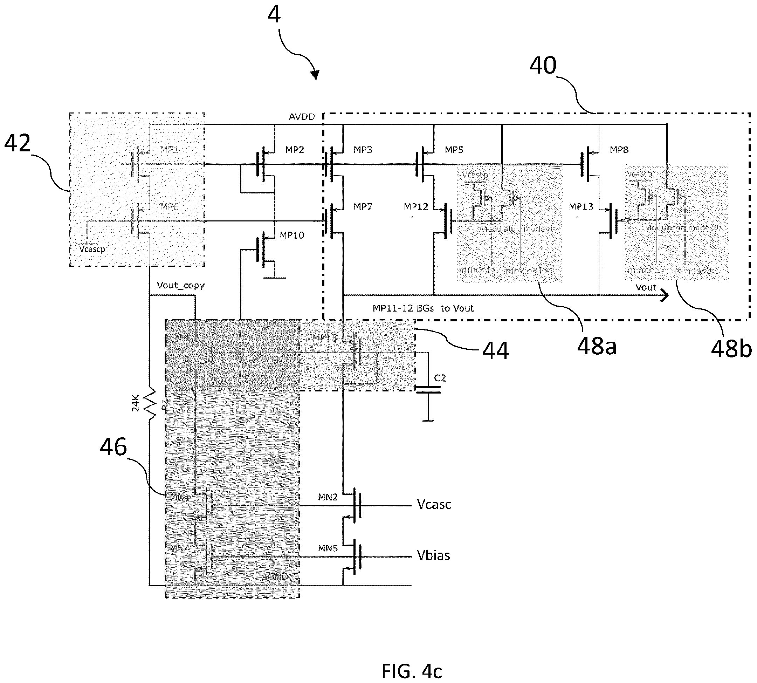

If output compliance allows, these MP6, MP7, MP12, MP13 devices may be changed to use the saturation region of operation. In this case, as shown in Figure 4b, the bias voltage may be desirably set to retain the devices in saturation but the devices may also transition from saturation, at least partly, to the linear region of operation in some use cases similar to cascode design used in known current mirror, or current replica, circuits. The gates of the variable current source cascodes may be switched between 'off' voltage and an 'on' cascode voltage. This should be done desirably with a break-before-make driver circuitry so that the cascode voltage is not shorted to the off-voltage source via the switching circuitry during transitions e.g. Fig 4c shows mcc<1> and mccb<1> control signals using acronyms in their naming to indicate control of the gates of modulator mode control one and modulator mode control bar, where bar is convention for an inverted or complementary version. These signals may be driven directly from synthesized digital, often auto-routed, or the switches may use hand-crafted digital switch driver designs optimized which may be optimized for low power and timing optimized for synchronization of the switching activity in multiple switched current source cascode devices.

The programmable current source is made up of four key subsystems, as shown in Figure 4a and specifically in Figure 4b, which are essentially a first components subsystem 40, a replica components subsystem 42, a replica bias circuit subsystem 44 and a current-to-voltage translator 46. The first components subsystem 40 is coupled between a supply and a critical node, such as Vout, that provides a 1st AC current path to flow into the critical node as a result of unwanted AC signals on the supply. The replica components subsystem 42 is coupled to the supply that produces a 2nd AC current output that is a ratioed replica of the 1st AC current. The replica bias circuit subsystem 44 sets the bias on the replica components to be equal or equivalent to that on the 1st components (even when the supply is varied). Finally, the current-to-voltage translator subsystem 46 receives some part of the 2nd AC current and supplies a 1st signal path and corresponding 1st signal from the current-to-voltage translator 46 to the replica component(s) 42 which, in response to this 1st signal, reduces the 2nd AC current. The current-to-voltage translator sub-system 46 also supplies a 2nd signal path and corresponding 2nd signal from the current-to voltage translator 46 to the first components subsystem 40, which in response to this 2nd signal, reduces the 1st AC current.

The present disclosure will now be discussed in more detail in relation to the associated Figures 3-7. Figure 3 shows a circuit diagram of the second and third stages of a buffer amplifier 3 including the programmable current source, I3, in accordance with an embodiment of the present disclosure. The majority of the buffer amplifier is common to that of the prior art circuitry as depicted in Figure 2. As such it comprises a chopping arrangement comprising a plurality of PMOS and NMOS devices, an input voltage, fixed current sources and a variable load, wherein the variable load is indicative of a downstream circuit load configuration, an output mode, a modulator mode or the like. However, Figure 3 further comprises a variable programmable current source, I3, which varies based upon the feedforward data from the system digital control or control input or modulator mode bus, which indicates the operating mode of the modulator i.e., what ADCs are currently operational, what parts of ADCs are currently operational, whether the ADCs are single ended or differential etc. The operating mode of the modulator may also indicate the number of currently operational DACs and there corresponding characteristics, or more generally may indicate the current demand of an analog load. It is worth noting that whilst DACs are conventionally known to provide relatively stable load conditions, some DACs can have highly variable load conditions. The circuit as described herewith is capable of supplying the necessary current to drive a plurality of load conditions including highly variable DAC loads for the reference buffer. There may be other indicators in the system e.g. a measurement or calibration value(s) which can be indicative of manufacturing variations which could also be used as an input to the amplifier output stage control. The programmable current source varies its output current based upon the feedforward data via the modulator mode bus which is indicative of the modulator mode. As such, the programmable current source varies its output current such that the connected devices MN4, MN5 and MN6 all operate with the same current density irrespective of the load conditions or modulator mode. This aids in making the voltage on the drains of MN1 and MN2 nominally constant over the chopping cycle and prevents the chopping square wave as in the prior art. The current source, I2, as in the prior art, may be still present within this circuitry however it is much smaller and is now sized to provide a nominal, reference bias current level for devices in the amplifier rather than be sized for the modulator mode associated with the maximum output load current. In the case where further calibration or trimming of the current source, I2, is required then this may be completed outside of this block before the nominal, reference bias current is provided. Further, it is worth noting that the current source, I2, is optional (as depicted by the dashed box in Figure 3) and if not present then the same functionality can be achieved solely by the variable current source, I3. The only difference that would occur in this scenario, is that the operating range of the variable current source would have a minimum value of 360uA rather than 0uA, according to the example disclosed in Figure 3.

In other words, it can be said that the fixed current source of Figure 2 has been spilt into a smaller fixed current source and a variable current source (the programmable current source). This can be seen in Figure 2 wherein I2 is supplying a current of 1.8mA. However, in Figure 3, I2 only now supplies 360uA to bias the NMOS/PMOS devices and I3 supplies a variable current of between 0 and 1260uA to drive the variable load associated with the different modulator modes. Therefore, when the modulator is in a no-load mode i.e., nothing is being used in the output stage, only 360uA is being supplied and thus there is a larger potential power saving.

To describe the second stage buffer amplifier 3 in more detail, the circuit is made up of four PMOS devices (MP1-MP4), six NMOS devices (MN1-MN6), three current sources (I1-I3) a resistor-capacitor arrangement (R1 and C1) and a variable load (R LOAD). The circuit also comprises a voltage high node, AVDD3p3, and a ground node, AGND. The circuit also comprises a modulator mode bus for communicating the current operating mode of the modulator including information indicative of the number of downstream ADCs that are operational, whether the ADCs are single ended or differential etc. It can be said that the NMOS and PMOS devices are arranged to create a transistor device network.

Further, the circuit comprises three voltage inputs, Vin, Vip and Vcasc. Vin and Vip are coupled to the gates of PMOS devices MP1 and MP2 respectively. The drains of MP1 and MP2 are coupled to the sources of MP3 and MP4 respectively. The gates of MP3 and MP4 are tied to ground. The sources of MP1 and MP2 are coupled to the voltage high node, AVDD3p3, via the current source, I1. Vcasc is coupled to the gates of NMOS devices MN1, MN2 and MN3. The drains of MN1 and MN2 are subsequently coupled to the drains of PMOS devices MP3 and MP4 respectively. The sources of MN1, MN2 and MN3 are coupled to the drains of MN4, MN5 and MN6 respectively, with the sources of MN4, MN5 and MN6 being tied to the ground node, AGND. The output of the reference buffer is coupled to the R1 and C1 series network wherein R1 and C1 are present to create a dominant pole in a Miller amplifier arrangement and therefore to create a stable output. The output of which drives the downstream ADC and therefore stability is of paramount importance.

Figure 4a shows the schematic circuit of the programmable current source, as discussed in relation to Figure 3. The programmable current source 4 is made up of four different subsystems: the first components 40, the replica components 42 which are arranged to have the same or equivalent voltages at their terminals as the first components, the replica bias circuit 44 which sets the bias on the replica components via the creation of a replica voltage Vout (known as Vout_copy) and the current to voltage translator 46.

To break the subsystems down further, the first components subsystem 40 comprises two example modulator mode inputs associated with the operating mode of the modulator and a plurality of PMOS devices. The modulator mode inputs (modulator_mode<1> and modulator_mode<0>) are coupled to the gate of PMOS devices MP12 and MP13 respectively. The sources of MP12 and MP13 are coupled to the drains of MP5 and MP8 respectively. In turn, the sources of MP5 and MP8 are coupled to the source AVDD whilst the gates of MP5 and MP8 are coupled to the gates of MP3 (also in the first components subsystem 40), MP2 and MP1 (part of the replica components subsystem 42). The drains of MP12 and MP13 are coupled to Vout. Further PMOS device MP7 source is coupled to the drain of MP3 and the gates of MP7 and MP6 (part of the replica components subsystem 42) are coupled to AGND. Finally, the drain of MP7 is coupled to Vout.

The replica components subsystem 42 comprises two PMOS devices, MP1 and MP6. The source of MP1 is coupled to the source, AVDD, whilst the drain is coupled to the source of MP6. As previously mentioned, the gate of MP1 is coupled to the gates of MP2, MP3, MP5 and MP8. The drain of MP6 is coupled to the resistor, R1, and the source of MP14 (part of the replica bias subsystem 44). The node coupling MP6, MP14 and R1 is considered the Vout_copy node. Further, the first components subsystem 40 comprises a first control terminal and the replica components subsystem 42 comprises a second control terminal, the first control terminal and the second control terminal may havesubstantially the same terminal voltage. Further, the first and second control terminals are coupled to the gates of MP1 and MP3/5/8 respectively.

The replica bias circuit subsystem 44 comprises two PMOS devices, MP14 and MP15. As previously mentioned, the source of MP14 is coupled to the Vout_copy node and by association coupled to R1 and the drain of MP6. The drain of MP14 is coupled to the drain of NMOS device MN1 (part of the current to voltage translator subsystem 46) as well as coupled to the gate of MP10. Finally, the gate of MP14 is coupled to the gate of MP15 and via C2 to an AC ground. The source of MP15 is coupled to the Vout node. The drain of MP15 is tied to its gate as well as coupled to the drain of NMOS device MN2. It can be seen that when MP14 and MP15 have the same gate length and are operated with the same current density that Vout_copy node will be at substantially the same voltage as Vout.

Finally in the example embodiment, the current to voltage translator subsystem 46 comprises a PMOS device, MP14 (also forms part of the replica bias circuit subsystem) and two NMOS devices, MN1 and MN4. As previously mentioned, the source of MP14 is coupled to the Vout_copy node and by association coupled to R1 and the drain of MP6. The drain of MP14 is coupled to the drain of NMOS device MN1 as well as coupled to the gate of MP10. Finally, the gate of MP14 is coupled to the gate of MP15 and via C2 to an AC ground. The source of MN1 is coupled to the drain of MN4. The gate of MN1 is coupled to the gate of MN2 and the node is considered to be the Vcasc node. The gate of MN4 is coupled to gate of MN5 and the node is considered to be the Vbias node. The sources of MN4 and MN5 are coupled the ground node, AGND.

Other components fall outside of a designated subsystem such as PMOS devices MP2 and MP10. MP2 and MP10 are critical for the first and second signal paths, to be described. The source of MP2 is coupled to source AVDD, the gate of MP2 is coupled to the gates of MP1, MP3, MP5 and MP8 and the drain of MP2 is coupled to the source of MP10 as well as to its own gate. The gate of MP10 is coupled to the drains of MP14 and MN1. The drain of MP10 is tied to ground.

The first components subsystem 40 is coupled between the supply, AVDD, and a critical node at Vout, that produces a first AC current to flow into the critical node as a result of unwanted AC signals on the supply. The replica components subsystem 42 is likewise coupled to the supply, AVDD, and produces a second AC current output that is a ratioed replica of the first AC current. The replica bias circuit subsystem 44 works in conjunction with the replica components subsystem 42, as the replica bias circuit subsystem 44 sets the bias on the replica components subsystem 42 to be equal or equivalent to that on the first components (even when the supply is varied). Further, the replica bias circuit subsystem 44 may be coupled to an impedance, a current source, a current sink to set a DC bias etc. The impedance can be made of one resistive device, a network of resistive devices or a same type e.g. using "unit" devices. Moreover, it may also use impedances of different types to achieve a particular desired characteristic. Active devices may also be used e.g to provide a variable or tunable impedance. The current to voltage translator subsystem 46 is the starting point for a first signal path and corresponding first signal running from the current to voltage translator 46 to the replica components 42 which, in response to this first signal, reduces the second AC current. The first signal path runs from the current to voltage translator through MP10 and towards MP1. There is a further second signal path and corresponding second signal running from the current to voltage translator 46 to the first components 40 which, in response to this second signal, reduces the first AC current. The second signal path couples the current to voltage translator through MP10 and MP2 and further couples to MP3, MP5 and MP8 within the first components subsystem. However, the first signal path and the second signal path may be distinct, the same (as shown here) or partly shared. It can be seen that the device MP1 is substantially identically biased to the output devices MP5 and MP8. For simplicity of explanation, we can consider all NMOS devices to be identically sized and all PMOS devices to be identically sized, except MP1 and MP6 which will effectively double the aspect ratio of all the other PMOS devices. As such, the following equation is true:

$$I_{D\_AC}MP1 = 2 * I_{D\_AC}MP8$$

During operation, a DC current flows from the drain of MP1 through MP6 to the high impedance node at the drain of MP14. An identical DC current will also flow from the drain of MP1 through MP6 and through R1 to ground. The high impedance node at the drain of MP14 is coupled via MP10 to the gate of MP1 to form a loop. From a DC standpoint, if Vout_copy falls below Vout, then less current flows into MP14 and the voltage on high impedance node MP14 drain falls. This in turn causes a lowering in voltage on MP10 source and in turn on MP1 gate. MP1 (and MP6) will then respond with an increase in drain current, which then causes the voltage on Vout_copy to rise towards the ideal voltage Vout. The operation is similar from an AC standpoint: Any unwanted AC current flowing from the supply AVDD through MP8 and MP13 to Vout will cause a corresponding AC current to flow through MP1 and MP6 to Vout_copy. This current (such as an increasing current) will largely flow through the low impedance source of MP14 to the high impedance node on MP14 drain causing a rise in voltage on the high impedance node. This rise in voltage will be translated to the gate of MP1 via MP10 which then responds to reduce this rise in current, such that the loop servos the MP1 AC current to nominally zero. Due to the arrangement of MP1 and MP8, if the MP1 drain AC current is zero, then so is the MP8 drain current. A resistor, such as R1, or a current source/sink may be coupled to the replica components in order to set a DC bias. Further, the current flowing towards Vout is ratio metric to the current in R1.

MP10 is arranged as a source follower and level shifts the voltage on the high impedance node on the drain of MP15 to the gate of MP1 to avoid MP14 coming out of saturation. In addition, MP10 also acts as a buffer, isolating the high impedance node from any AC currents flowing from the gates of MP1, MP2, MP3, MP5 and MP8. For correct operation of this circuit, the only AC currents that can flow into the high impedance node are those emanating from MP6 drain. In some circumstances the AC gate currents flowing from MP1, MP2, MP3, MP5 and MP8 may be small enough such that no buffer is required and in some arrangements no level shifter will be required.

As a modification to this embodiment MP12-13 instead of being employed as switches can be configured as switchable cascodes. MP12-13 gates are then independently connectable to a new cascode bias voltage or to a turn off voltage such as AVDD while MP6-7 are connected to the new cascode bias voltage.

Figure 4b shows a simplified block diagram of the aforementioned schematic as discussed in relation to Figure 4a. Figure 4b shows the simplified relationships between the first components subsystem 40, the replica components subsystem 42, the replica bias circuit subsystem 44 and the current to voltage transformer subsystem 46. It should be noted that some components are involved in more than one subsystem and thus may serve a purpose in more than one sub block, for example MP14 performs a function in both the replica bias circuit subsystem 42 and the current to voltage translator subsystem 46. In other words, there is overlap between the replica bias circuit subsystem and the current to voltage translator subsystem.

Figure 4c shows an alternative schematic diagram of a programmable current source (as in Figure 3). It can be seen that the figure illustrates an alternative embodiment of the programmable current sources as depicted in Figure 4a. As such, the figure has a largely corresponding arrangement to that of Figure 4a but only differs through the arrangement of the control input or modulator mode input. The control inputs that are coupled to the gates of MP12 and MP13 in Figure 4a are replaced by the double cascode 48a-b arrangement 48a-b in Figure 4c wherein the control inputs mmc<1>, mmcb<1>, mmc<0> and mmcb<0> are coupled to the gates of the respective cascodes. The drains of said cascodes are then coupled to MP12 and MP13 respectively. One cascode source pin in each double cascode arrangement is coupled to the AVDD node and the other cascode source pin in each double cascode arrangement is coupled to a Vcascp pin.

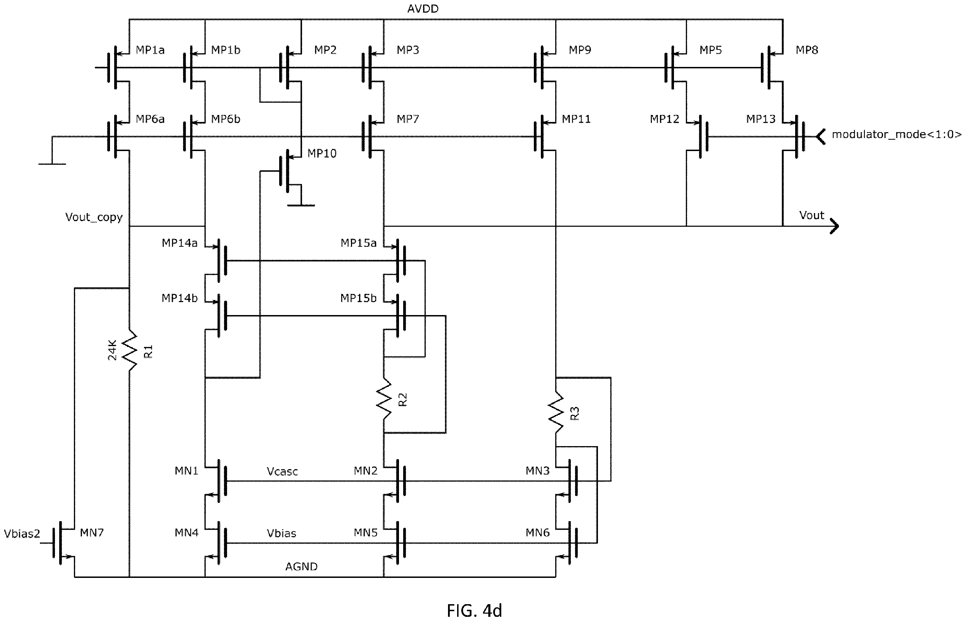

Figure 4d shows a more complete schematic with all the devices shown in Figure 4a included. In this embodiment, the voltages Vbias and Vcasc are generated internally with additional devices MP9, MP11, MP3 and MP6, along with resistor R3. Also, for more accurate generation of the Vout_copy node, cascodes MP14b and MP15b are added, along with biasing resistor r2, to better match the drain voltages of MP14a and MP15a. Also note the addition of MN7 biased by gate voltage Vbias2 to provide a current path. This may be appropriate when a constant current is required, independent of the voltage on Vout. MN7 is shown in addition to R1 but can also replace R1. Vbias can be a fixed voltage or can be a variable voltage, in which case MN7 can be considered a variable current source. In another example MN7 gate voltage can be operated dynamically e.g., can be turned on for a finite period of time while the currents in the programmable current source are established. This may be necessary as this circuit, when biased solely by resistor R1, can have a stable state where zero current flows in all devices. Alternatively, for low power circuits, dynamic switching of MN7 can speed up the turn on time of the circuit.

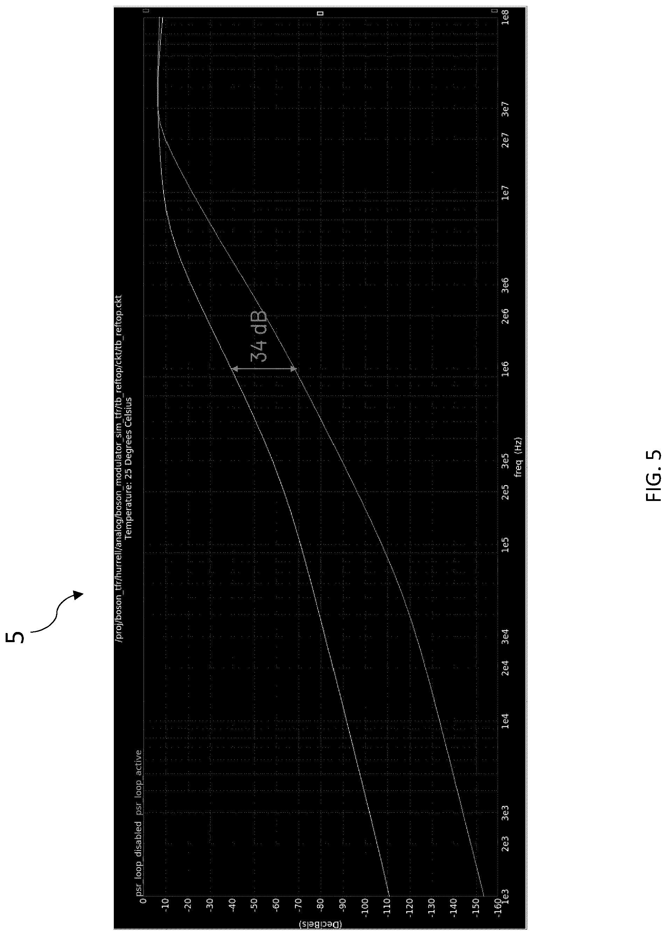

Figure 5 shows a simulated frequency response graph 5 showing a performance model comparison when the Power Supply Rejection (PSR) loop is disabled versus enabled in an example embodiment. It can be seen that the PSR loop has a significant positive effect on the performance of the circuit indicating that the PSR loop vastly reduces coupling from the supply to Vout. To highlight this more clearly, Figure 5 shows that at a frequency of 1MHz the PSR loop provides a 34dB reduction in power supply variation coupling to Vout. As such, there is a very significant reduction in AC disturbing currents.

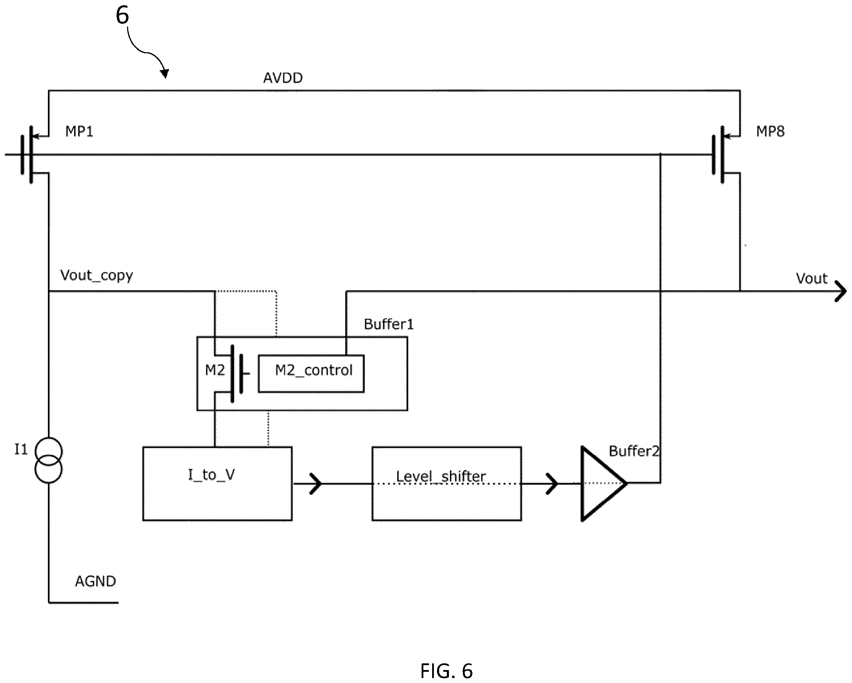

A simplified, generalised circuit diagram 6 of the programmable current source is shown in Figure 6. It can still be seen that the replica component subsystem is present as MP1 and the first component subsystem is present as MP8. Likewise, the current to voltage translator is shown as I_to_V. The Level_shifter and Buffer2 is performed by MP10 as shown in Figure 4a. Both the Level_shifter and the Buffer2 are optional components and can also be swapped round in arrangement i.e., the buffer may be arranged to be before the level shifter. The level shifting can alternatively be achieved via a battery cap (as described in US 10,931,122 B2), wherein a battery capacitor may be more commonly referred to as a supercapacitor or a ultracapacitor i.e., a capacitor that substantially retains its relative charge level whilst under load for short time durations.

Moreover, it is worth noting that output stage variations of the present disclosure may use degeneration to balance current distribution within the output stage. The output stage may use scaling and/or segmentation [2].

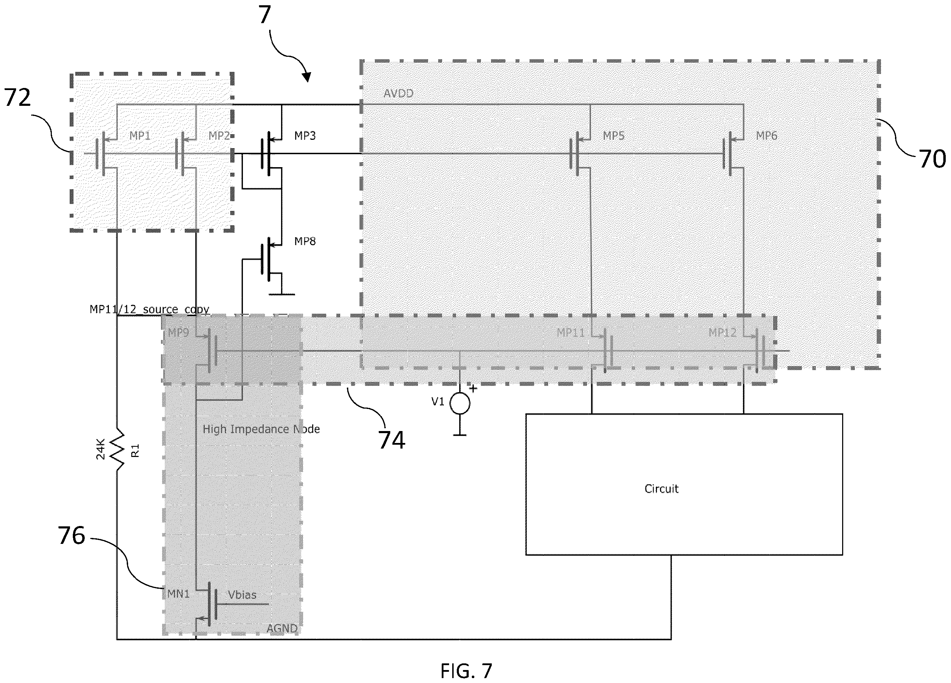

Figure 7 shows a schematic diagram of a clean current source circuit 7 for a secondary circuit, in accordance with a further embodiment of the present disclosure. It can be seen that the circuit is very similar to the circuit in Figure 4a, however, provides fixed currents to a secondary circuit that is largely immune to unwanted disturbances on the supply AVDD.

Like Figure 4a, the clean current source circuit 7 contains four main subsystems: the first components subsystem 70, the replica components subsystem 72, the replica bias subsystem 74 and the current to voltage translator subsystem 76.

To break the subsystems down further, the first components subsystem 70 comprises a plurality of PMOS devices, MP5-MP6 and MP11-MP12. The sources of MP5 and MP6 are tied to the high voltage node, AVDD. The drains of MP5, MP6 are coupled to the sources of MP11 and MP12 respectively. The gates of MP5 and MP6 are tied together and tied to the gates of MP1, MP2 and MP3 (MP1 and MP2 form part of the replica components subsystem 72). The gates of MP11 and MP12 are tied together along with the gate of MP9 which is present in both the replica bias subsystem 74 and the current to voltage translator subsystem 76. The drains of MP11 and MP12 provide the current outputs to the circuit block. It is worth noting that the present embodiment, as disclosed in Figure 7 is similar to the arrangement of Figure 3, in that it uses the same PSR technique but rather than driving a single load at Vout, it is providing one or more clean current sources for a circuit (such as an operational amplifier) which will typically need multiple current sources.

The replica components subsystem 42 comprises two PMOS devices, MP1 and MP2. The sources of MP1 and MP2 are coupled to the source, AVDD, whilst the drain of MP1 and MP2 are coupled to the source of MP9. As previously mentioned, the gates of MP1 and MP2 are coupled to the gates of MP2, MP3, MP4, MP5 and MP6. The drain of MP2 is coupled to the resistor, R1, and the source of MP9 (part of the replica bias subsystem 74 and the current to voltage translator 76). The node between MP1, MP2, MP9 and R1 is considered the MP11/12_source_copy node.

The replica bias circuit subsystem 74 comprises three PMOS devices, MP9, MP11 and MP12. As previously mentioned, the source of MP9 is coupled to the MP11/12_source_copy node and by association coupled to R1 and the drains of MP1 and MP2. The drain of MP9 is coupled to the drain of NMOS device MN1 (part of the current to voltage translator subsystem 76).

The current to voltage translator subsystem 76 comprises a PMOS device, MP9 (also forms part of the replica bias circuit subsystem 74) and NMOS device, MN1. As previously mentioned, the source of MP9 is coupled to the MP11/12_source_copy node and by association coupled to R1 and the drain of MP1/MP2. The drain of MP9 is coupled to the drain of NMOS device MN1 as well as coupled to the gate of MP8. The source of MN1 is coupled to the ground pin, AGND.

The first and second signal and first and second signal path occur in the same manner as in Figure 4a, however, they occur via MP8 and MP3 in Figure 7 rather than MP10 and MP2 as in Figure 4a. The main difference between the circuit in Figure 4a and the circuit in Figure 7 is that the clean current source 7 does not have any control input or modulation mode bus and therefore does not receive feedforward data indicative of the downstream operation, modulation mode or load scenario. Instead of the gates of the appropriate PMOS devices (MP12 and MP13) in Figure 4a being coupled to modulation mode inputs or control inputs, the gates of the appropriate PMOS devices (MP11 and MP12) in Figure 7 are tied to the gate of PMOS devices (MP9) in the replica bias subsystem 74. As such, MP9 has the same source gate voltage as MP11 and MP12 so that the voltages on the new critical nodes MP11 and MP12 sources are replicated on the node "MP11/12_source_copy". V1 is a voltage source that sets the gate voltages of MP9, MP11 and MP12. There is no requirement for this voltage source to be a fixed voltage and it can be dependent on a node voltage within the circuit or elsewhere. Alternatively, it may be dependent on temperature, for example to maximise headroom of MP11/12 over the temperature range of operation.

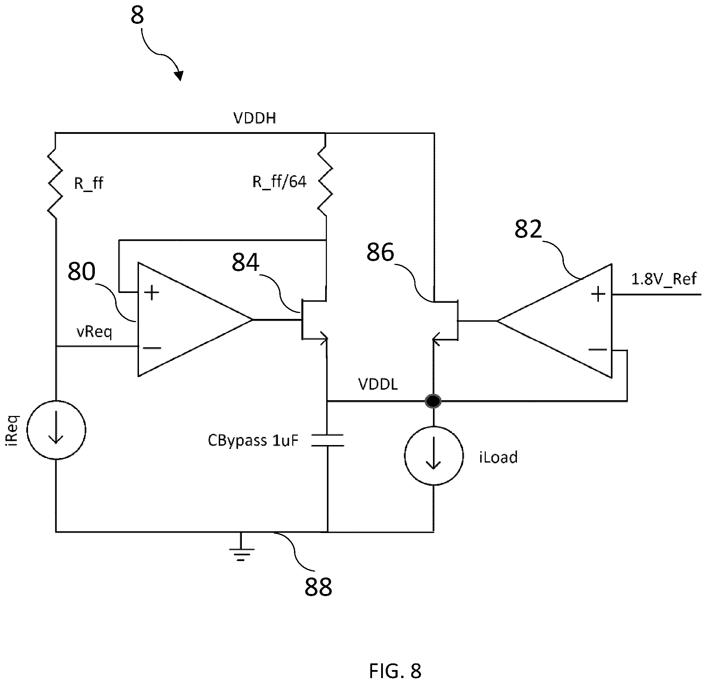

Figure 8 shows a simplified schematic diagram of a split current source arrangement 8, in accordance with a further embodiment of the present disclosure. The circuit comprises a network comprising two resistors or impedances (R_ff (first impedance) and R_ff/64 (second impedance)), two operational amplifier devices 80 (first operational amplifier), 82 (second operational amplifier), a first current sink, iReq, a first transistor device or NMOS device 84, a second transistor device or NMOS device 86, and a capacitor (C_{Bypass}) and a second current sink, iLoad. The split current source arrangement 8 also comprises a high voltage node, VDDH, and a ground node, 88. It is worth noting that whilst embodiments are discussed in relation to current sources, the solution may also be inverted to provide a current source of negative polarity, commonly termed a current sink.

Further, the high voltage node or voltage supply, VDDH, is coupled directly to the drain of the NMOS device, 86 and coupled to the drain of NMOS device 84 via resistor, R_ff/64. Both gates of NMOS device 84 and NMOS device 86 are coupled to the output of operational amplifier 80 and operational amplifier 82 respectively. The drain of NMOS device 84 is coupled to the positive input of operation amplifier 80, whereas the source of NMOS device 86 is coupled to the negative input of operational amplifier 82. The positive input of the operation amplifier 82 is attached to a 1.8V reference (1.8V_ref). The negative terminal of the operational amplifier 80 is coupled to the node intersecting VDDH, via R_ff, and GND 88 via current sink, iReq. The current sink, iReq, is the feedforward current information from the circuitry. The sources of NMOS device 84 and NMOS device 86 are coupled together, with the source connection leg of NMOS device 84 being coupled to GND 88 via the capacitor, C_{Bypass}, and the source connection leg of NMOS device 86 being coupled to GND 88 via the load, iLoad.

The circuit of Figure 8 provides a similar operation to that of Figure 3, in accordance with a further embodiment of the present disclosure. In this embodiment, rather than the feedforward arrangement of Figure 3 which utilises the Modulation Mode bus to feed forward information indicative of load conditions and downstream circuit operation, Figure 8 uses a feedback arrangement. This is achieved by the circuit looking at the load which is currently being driven and then providing this small current, which is a measure of iLoad through the resistor, R_ff, to generate a voltage which is copied by operational amplifier, 80. In this arrangement, the iReq current may equal 1/65th of the overall current. The load represented by the current sink, iLoad, can be a transistor circuit such as an operational amplifier. In nearly all such circuits, current sinks are required to bias various stages within the amplifier. Typically, these current sinks in a CMOS circuit are made from ratioed, or replica, NMOS device(s) sharing a common gate and with sources connected to ground. The gate voltage may be generated by a diode connected device. Where iLoad is represented by such a circuit, an extra NMOS current sink would be provided, forming a current mirror with the diode connected device, sized so that this current sink's current is, for example, 1/65th of the current of the whole amplifier (and is represented in Figure 8 by current sink iReq). The generation of iReq can be considered as an indirect measurement of the load current. R_ff, amplifier 80, R_ff/64 and NMOS device 84 multiply this current by a factor of 64 so the current supplied by NMOS device 84 is equal to a fraction 64/65 of the iLoad current. As such NMOS device 86 need only source 1/65th of the load current. It is worth noting that the values of R_ff and R_ff/64 provided here are for exemplary purposes only. The values of R_ff and R_ff/64 can be varied according to the ratios of current that the designer would prefer the NMOS device 84 and the NMOS device 86 to source.

In an alternative embodiment, iReq could be the current in the drain of MN7 of Figure 4d (with R1 removed), where MN7 is the output device of a current mirror and Vbias2 is connected to the diode connected device within the circuit. In such an arrangement MP5 and MP8 would be sized to provide the current that is supplied by NMOS device 84 in Figure 8. In this feedback arrangement the node Vout_copy is the control input with the current in MN7 being the control information (rather than the modulator_modulator mode bus, which would just be grounded to turn on MP12 and MP13).

A motivation for such an arrangement is that during load switching the circuit can operate and react faster to replicate the under load current conditions, since amplifier 82 is only needing to make small changes in the current supplied by NMOS device 86 to make a large change in the iLoad current. Thus, the voltage glitching effect is once again reduced. Therefore, the circuit provides a more stable output voltage under scenarios of variable load.

While the current source implementation has a nominal value, using the variable current source in conjunction with a driver may justify output current limiting within the driver. The programmable current source short circuit current may be largely self-limiting.

The preferred embodiments, as explained herewith, use static encoding which is commonly desirable to reduce design complexity, verification, and validation. There are many variations of dynamic element matching (DEM) may also be used to vary the devices selected to randomize or noise-shape the impact of mismatch, as the cost of additional design complexity, as is known to those skilled in the art [3].

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to."

The words "coupled" or "connected" or "tied", as generally used herein, refer to two or more elements or nodes that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list.

It will be understood that the above list is non-exhaustive, and that the method and system described herein is applicable to many technical problem domains to which machine learning models may be applied.

It is worth noting, that while example embodiments have been presented in relation to NMOS and PMOS transistor devices, the present disclosure could be implemented using varying transistor devices such as CMOS, BiCMOS, BJT, JFET etc.

Various modifications, whether by addition, substitution, or deletion will be apparent to the intended reader to provide further embodiments of the present disclosure, any and all of which are intended to be encompassed by the appended claims.

There follows a series of numbered clauses each defining an example of the present disclosure. Where a numbered clause refers to an earlier numbered clause then the features of those clauses should be considered together in combination.

[Clause 1] A buffer amplifier circuit, comprising:

a driver that supplies current to a load in dependence on a voltage on the variable load;
at least one variable current source, the variable current source being arranged in use to supply current to the variable load; and
a control input receiving control information pertaining to a current demand of the load;
the arrangement being such that the variable current source is controlled in dependence on the received control information to vary its output current such that current from the driver and the variable current source address the current requirements of the load, with at least a majority of the current requirements of the load being supplied by the variable current source.

[Clause 2] The circuit of clause 1, wherein the driver is the output stage of an operational amplifier.

[Clause 3] The circuit of clauses 1 or 2, wherein the driver is separate from the at least one variable current source.

[Clause 4] The circuit of any of the preceding clauses, wherein all of the current requirements of the variable load are supplied by the variable current source.

[Clause 5] The circuit of any of the preceding clauses, wherein the control input receives digital information pertaining to the current demand of the load.

[Clause 6] The circuit of any of the preceding clauses, wherein the control input receives control information related to the magnitude of the load current from a direct or indirect measurement of the load current.

[Clause 7] The circuit of clause 6, wherein the control information is generated using a current mirror.

[Clause 8] The circuit of clause 7, wherein the control information is a current and sets a bias in the variable current source.

[Clause 9] The circuit of any of the preceding clauses, wherein the at least one variable current source comprises the following subsystems:

a first components subsystem, wherein the first components subsystem is coupled between a supply and a critical node to produce a first AC current to flow into the critical node as a result of unwanted AC signals on the supply;
a replica components subsystem wherein the replica components subsystem is coupled to the supply to produce a second AC current that is a ratioed replica of the first AC current;
a replica bias circuit subsystem wherein the replica bias circuit is arranged to: set the bias conditions of the components within the replica components subsystem to be equal or equivalent to that of the components within the first components subsystem and further arranged to be coupled to an impedance, current source, or current sink to set a DC bias; and
a current to voltage translator subsystem wherein the current to voltage translator subsystem produces:

(i) a first signal via a first signal path which reduces the second AC current, wherein the first signal path couples the current to voltage translator subsystem to the replica components subsystem; and
(ii) a second signal via a second signal path which reduces the first AC current, wherein the second signal path couples the current to voltage translator subsystem to the first components subsystem.

[Clause 10] The circuit of clause 9, wherein one or more of the first and second signal paths includes a buffer.

[Clause 11] The circuit of clause 9 or 10, wherein one or more of the first and second signal paths includes a level shifter wherein the level shifting is provided by a threshold in a transistor device or a battery cap.

[Clause 12] A split current source circuit, comprising at least:

a first operational amplifier, a first transistor device, a first impedance and a second impedance which are arranged to produce a first current through a first current source;
a second operational amplifier and a second transistor device which arranged to produce a second current through a second current source;
the second operational amplifier, the second transistor device, the first impedance and the second impedance being arranged to produce the second current through the second current source; and
wherein the first current is a multiple of the second current, the multiple being dependent upon the relative values of the first and second impedances.

[Clause 13] A current source circuit, comprising:

a first components subsystem coupled between a supply and a critical node that produces a first AC current to flow into the critical node as a result of unwanted AC signals on the supply;
a replica components subsystem coupled to the supply to produce a second AC current that is a ratioed replica of the first AC current;
a replica bias circuit subsystem arranged in use to set bias conditions of the components within the replica components subsystem to be equal or equivalent to that of the components within the first components subsystem; and
a current to voltage translator subsystem arranged in use to produce:

i) a first signal via a first signal path which reduces the second AC current, wherein the first signal path couples the current to voltage translator subsystem to the replica components subsystem; and
ii) a second signal via a second signal path which reduces the first AC current, wherein the second signal path couples the current to voltage translator subsystem to the first components subsystem.

[Clause 14] The circuit of clause 13, wherein the control terminal voltage of the first components subsystem is the same as the control terminal voltage of the replica components subsystem.

[Clause 15] The circuit of clause 13 or 14, wherein the first signal path and the second signal path can be distinct, the same or partly shared.

[Clause 16] The circuit of any of clauses 13 to 15, wherein the circuit further comprises a level shifter within the first and/or second signal paths.

[Clause 17] The circuit of any of clauses 13 to 16, wherein the circuit further comprises a buffer within the first and/or second signal paths.

[Clause 18] The circuit of any of clauses 13 to 17, wherein the first components subsystem comprises a first control terminal and the replica components subsystem comprises a second control terminal, the first control terminal and the second control terminal having substantially the same terminal voltage.

[Clause 19] The circuit of any of clauses 13 to 18, wherein the source of a transistor device, arranged as a voltage follower, is coupled to the replica components subsystem, the drain couples directly or indirectly to an output of the current to voltage translator subsystem and the gate of the source follower is biased to set bias conditions of components within the replica components subsystem to be equal or equivalent to components in the first components subsystem.

[Clause 20] The circuit of any of clauses 13 to 19, wherein the critical node is the source of one or more transistor devices biased as cascodes and the drains of the cascodes supply current to components within a circuit such as operational amplifier.

## References

[1] C. C. Enz and G. C. Temes, "Circuit techniques for reducing the effects of op-amp imperfections: autozeroing, correlated double sampling, and chopper stabilization," in Proceedings of the IEEE, vol. 84, no. 11, pp. 1584-1614, Nov. 1996, doi: 10.1109/5.542410.

[2] Manganaro, Gabriele. Advanced data converters. Cambridge University Press, 2011.

[3] Schreier, Richard, and Gabor C. Temes. Understanding delta-sigma data converters. Vol. 74. Piscataway, NJ: IEEE press, 2005.

## Claims

1. A buffer amplifier circuit, comprising:

   a driver that supplies current to a load in dependence on a voltage on the variable load;
   at least one variable current source, the variable current source being arranged in use to supply current to the variable load; and
   a control input receiving control information pertaining to a current demand of the load;
   the arrangement being such that the variable current source is controlled in dependence on the received control information to vary its output current such that current from the driver and the variable current source address the current requirements of the load, with at least a majority of the current requirements of the load being supplied by the variable current source.

2. The circuit of claim 1, wherein the driver is one or more of the following:

   a) the output stage of an operational amplifier; and/or
   b) separate from the at least one variable current source.

3. The circuit of claims 1 or 2, wherein all of the current requirements of the variable load are supplied by the variable current source.

4. The circuit of any of the preceding claims, wherein the control input receives digital information pertaining to the current demand of the load.

5. The circuit of any of the preceding claims , wherein the control input receives control information related to the magnitude of the load current from a direct or indirect measurement of the load current.

6. The circuit of claim 5, wherein the control information is generated using a current mirror; wherein optionally the control information is a current and sets a bias in the variable current source.

7. The circuit of any of the preceding claims , wherein the at least one variable current source comprises the following subsystems:

   a first components subsystem, wherein the first components subsystem is coupled between a supply and a critical node to produce a first AC current to flow into the critical node as a result of unwanted AC signals on the supply;
   a replica components subsystem wherein the replica components subsystem is coupled to the supply to produce a second AC current that is a ratioed replica of the first AC current;
   a replica bias circuit subsystem wherein the replica bias circuit is arranged to: set the bias conditions of the components within the replica components subsystem to be equal or equivalent to that of the components within the first components subsystem and further arranged to be coupled to an impedance, current source, or current sink to set a DC bias; and

a current to voltage translator subsystem wherein the current to voltage translator subsystem produces:

(i) a first signal via a first signal path which reduces the second AC current, wherein the first signal path couples the current to voltage translator subsystem to the replica components subsystem; and
(ii) a second signal via a second signal path which reduces the first AC current, wherein the second signal path couples the current to voltage translator subsystem to the first components subsystem.

8. The circuit of claim 7, wherein one or more of the first and second signal paths includes one or more of the following:

a) a buffer; and/or
b) a level shifter wherein the level shifting is provided by a threshold in a transistor device or a battery cap.

9. A split current source circuit, comprising at least:

a first operational amplifier, a first transistor device, a first impedance and a second impedance which are arranged to produce a first current through a first current source;
a second operational amplifier and a second transistor device which arranged to produce a second current through a second current source;
the second operational amplifier, the second transistor device, the first impedance and the second impedance being arranged to produce the second current through the second current source; and
wherein the first current is a multiple of the second current, the multiple being dependent upon the relative values of the first and second impedances.

10. A current source circuit, comprising:

a first components subsystem coupled between a supply and a critical node that produces a first AC current to flow into the critical node as a result of unwanted AC signals on the supply;
a replica components subsystem coupled to the supply to produce a second AC current that is a ratioed replica of the first AC current;
a replica bias circuit subsystem arranged in use to set bias conditions of the components within the replica components subsystem to be equal or equivalent to that of the components within the first components subsystem; and

a current to voltage translator subsystem arranged in use to produce:

i) a first signal via a first signal path which reduces the second AC current, wherein the first signal path couples the current to voltage translator subsystem to the replica components subsystem; and
ii) a second signal via a second signal path which reduces the first AC current, wherein the second signal path couples the current to voltage translator subsystem to the first components subsystem.

11. The circuit of claim 10, wherein a control terminal voltage of the first components subsystem is the same as a control terminal voltage of the replica components subsystem.

12. The circuit of claims 10 or 11, wherein the circuit further comprises one or more of a a level shifter and/or a buffer within the first and/or second signal paths.

13. The circuit of any of claims 10 to 12, wherein the first components subsystem comprises a first control terminal and the replica components subsystem comprises a second control terminal, the first control terminal and the second control terminal having substantially the same terminal voltage.

14. The circuit of any of claims 10 to 13, wherein a source of a transistor device, arranged as a voltage follower, is coupled to the replica components subsystem, a drain of the transistor device couples directly or indirectly to an output of the current to voltage translator subsystem and a gate of a source follower is biased to set bias conditions of components within the replica components subsystem to be equal or equivalent to components in the first components subsystem.

15. The circuit of any of claims 10 to 14, wherein the critical node is a source terminal of one or more transistor devices biased as cascodes, wherein drain terminals of the cascodes supply current to components within a circuit such as an operational amplifier.

FIG. 1

EP 4 502 755 A1

FIG. 2

FIG. 3

EP 4 502 755 A1

FIG. 4a

FIG. 4b

EP 4 502 755 A1

FIG. 4c

FIG. 4d

EP 4 502 755 A1

FIG. 5

FIG. 6

FIG. 7

FIG. 8

Europäisches
Patentamt

European
Patent Office

Office européen
des brevets

## EUROPEAN SEARCH REPORT

**Application Number**

EP 24 19 1603

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NAN YANG ET AL: "Replica-Based Low Drop-Out Voltage Regulator with Assistant Power Transistors for Digital VLSI Systems", 2018 IEEE COMPUTER SOCIETY ANNUAL SYMPOSIUM ON VLSI (ISVLSI), IEEE, 8 July 2018 (2018-07-08), pages 6-9, XP033382355, DOI: 10.1109/ISVLSI.2018.00012 [retrieved on 2018-08-07] | 1,2,4-6, 9 | INV. G05F1/46 H03F1/02 H03F1/14 H03F1/22 H03F3/393 H03F3/45 G05F3/26 |
| A | * page 6, left-hand column, line 19 - page 9, left-hand column, line 16; figures 1-9 * | 3,7,8, 10-15 | |
| | ----- | | |
| X | US 2016/357205 A1 (SANASI ALESSANDRO [IT] ET AL) 8 December 2016 (2016-12-08) | 1,2,4-6 | |
| A | * paragraphs [0003] - [0094]; figures 1-12 * | 3,7-15 | |
| | ----- | | |
| X | US 2016/056798 A1 (CHAN HAO-CHIEH [TW]) 25 February 2016 (2016-02-25) | 1-3,5,6 | **TECHNICAL FIELDS SEARCHED (IPC)** |
| A | * paragraph [0001-]; figures 1-4 * | 4,7-15 | H03F G05F |
| | ----- | | |

The present search report has been drawn up for all claims

1

| Place of search | Date of completion of the search | Examiner |
|---|---|---|
| The Hague | 28 November 2024 | Fedi, Giulio |

EP 4 502 755 A1

## ANNEX TO THE EUROPEAN SEARCH REPORT
## ON EUROPEAN PATENT APPLICATION NO.

EP 24 19 1603

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2024

| Patent document cited in search report | Publication date | Patent family member(s) | | Publication date |
|---|---|---|---|---|
| US 2016357205 A1 | 08-12-2016 | KR 20160142780 A | | 13-12-2016 |
| | | US 2016357205 A1 | | 08-12-2016 |
| US 2016056798 A1 | 25-02-2016 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 10931122 B2

### Non-patent literature cited in the description

- **C. C. ENZ** ; **G. C. TEMES**. Circuit techniques for reducing the effects of op-amp imperfections: autozeroing, correlated double sampling, and chopper stabilization. *Proceedings of the IEEE*, November 1996, vol. 84 (11), 1584-1614
- **MANGANARO, GABRIELE**. Advanced data converters. Cambridge University Press, 2011
- **SCHREIER, RICHARD** ; **GABOR C. TEMES**. Understanding delta-sigma data converters. IEEE press, 2005, vol. 74